# EUROPÄISCHE PATENTSCHRIFT

(11) **EP 0 777 909 B1**
(45) Veröffentlichungstag und Bekanntmachung des Hinweises auf die Patenterteilung: **14.10.1998**
(21) Anmeldenummer: 95928963.8
(22) Anmeldetag: 23.08.1995
(51) Int. Cl.: H01J 37/06, H01J 3/40, H01J 29/84

(54) **ELEKTRONENSTRAHL-ERZEUGER**
ELECTRON BEAM GENERATOR
GENERATEUR DE FAISCEAU ELECTRONIQUE

(30) Priorität: 27.08.1994 DE 4430534
(43) Veröffentlichungstag der Anmeldung: 11.06.1997
(73) Patentinhaber: Heidelberger Druckmaschinen Aktiengesellschaft, 69115 Heidelberg (DE)
(72) Erfinder: SERMUND, Gerald, Johannes, D-24118 Kiel (DE); HERB, Roland, D-72144 Dusslingen (DE); HERRMANN, Karl-Heinz, D-72127 Wankheim (DE); NISCH, Wilfried, Hermann, D-72072 Tübingen (DE)
(86) Internationale Anmeldenummer: DE9501113
(87) Internationale Veröffentlichungsnummer: WO9607195

(56) Entgegenhaltungen:
- GB-A- 2 052 847
- US-A- 3 406 273
- US-A- 3 845 346
- US-A- 4 155 028

## Beschreibung

Die Erfindung betrifft einen Elektronenstrahl-Erzeuger, bestehend aus einer Elektronen emittierenden Kathode, einer Anode mit einer Anodenbohrung zum Durchtritt des Elektronenstrahles entlang einer Strahlenachse und aus einer Wehneltelektrode zur Steuerung des Elektronenstrahles, wobei Kathode, Anode und Wehneltelektrode in einer Vakuumkammer angeordnet sind.

Ein Elektronenstrahl-Erzeuger findet in Elektronenstrahl-Geräten für die Materialbearbeitung Anwendung, beispielsweise in Elektronenenstrahl-Graviereinrichtungen für die Gravur von Druckformen für den Tiefdruck in der Reproduktionstechnik oder für die Gravur von Oberflächenstrukturen auf Texturwalzen, mit denen in Walzwerken Feinbleche zur Qualitätsverbesserung bearbeitet werden.

Eine Elektronenstrahl-Graviereinrichtung für Druckformen oder Texturwalzen ist beispielsweise aus der DE-A-40 32 918 bekannt. Die Elektronenstrahl-Graviereinrichtung besteht im wesentlichen aus einer ersten Vakuumkammer, in der ein Elektronenstrahl-Erzeuger und ein elektronenoptisches Steuerungssystem für den Elektronenstrahl untergebracht sind, und aus einer zweiten Vakuumkammer, in der sich die Druckform oder Texturwalze zur Gravur mit dem Elektronenstrahl befindet. Der Elektronenstrahl-Erzeuger besteht im wesentlichen aus einer Kathode, einer Anode mit einer Anodenbohrung und aus einer Wehneltelektrode. Die den Elektronenstrahl erzeugenden Elektronen werden von der beheizten Kathode, die auf Hochspannungspotential liegt, emittiert, und in Richtung auf die Anode, die beispielsweise Nullpotential hat, beschleunigt. Der Elektronenstrahl wird durch die Anodenbohrung dem elektronenoptischen Steuerungssystem zugeführt und tritt dann durch eine Öffnung in der ersten Vakuumkammer in die zweite Vakuumkammer als Arbeitskammer ein, um die Druckform oder die Texturwalze zu bearbeiten.
Bei Elektronenstrahl-Geräten wie beispielsweise den Elektronenstrahl-Graviereinrichtungen, die mit Hochspannung im kV-Bereich und im Hochvakuum betrieben werden, treten im Elektronenstrahl-Erzeuger lonen auf, die durch lonisation von Restgasmolekülen entstehen. Diese lonen werden auf die Kathode beschleunigt und zerstören durch Materialabtrag die Kathode, wobei insbesondere aus dem Beschleunigungsraum stammende, dicht vor der Kathode gebildete lonen an der Zerstörung der Kathode beteiligt sind.

Die Zerstörung der Kathode durch den lonenbeschuß macht häufige Wartungsarbeiten an dem Elektronenstrahl-Erzeuger erforderlich, bei denen die zerstörte Kathode gegen eine neue Kathode ausgetauscht werden muß. Die Wartungsarbeiten führen in nachteiliger Weise zu Stillstandszeiten der Elektronenstrahl-Geräte. Darüber hinaus wird durch den vom lonenbeschuß verursachten Materialabtrag von der Kathode die aktive Emissionsfläche verkleinert und das charakteristische Stromdichteprofil des Elektronenstrahles in nachteiliger Weise verändert.

Aufgabe der vorliegenden Erfindung ist es daher, einen Elektronenstrahl-Erzeuger derart zu verbessern, daß die nutzbare Zeit der Kathode erhöht und dadurch ein nahezu wartungsfreier Betrieb ermöglicht wird.

Diese Aufgabe wird erfindungsgemäß durch die im Anspruch 1 angegebenen Merkmale gelöst.

Vorteilhafte Weiterbildungen sind in den Unteransprüchen angegeben.

Die Erfindung wird nachfolgend anhand der Fig. 1 bis 3 näher erläutert.

Es zeigen:
- Fig. 1: den schematischen Aufbau eines Elektronenstrahl-Erzeugers in einem Schnittbild,
- Fig. 2: den Elektronenstrahl-Erzeuger in einem um 90° um eine Strahlenachse gedrehten Schnittbild **und**
- Fig. 3: ein Ausführungsbeispiel für einen magnetischen lonen-Separator.

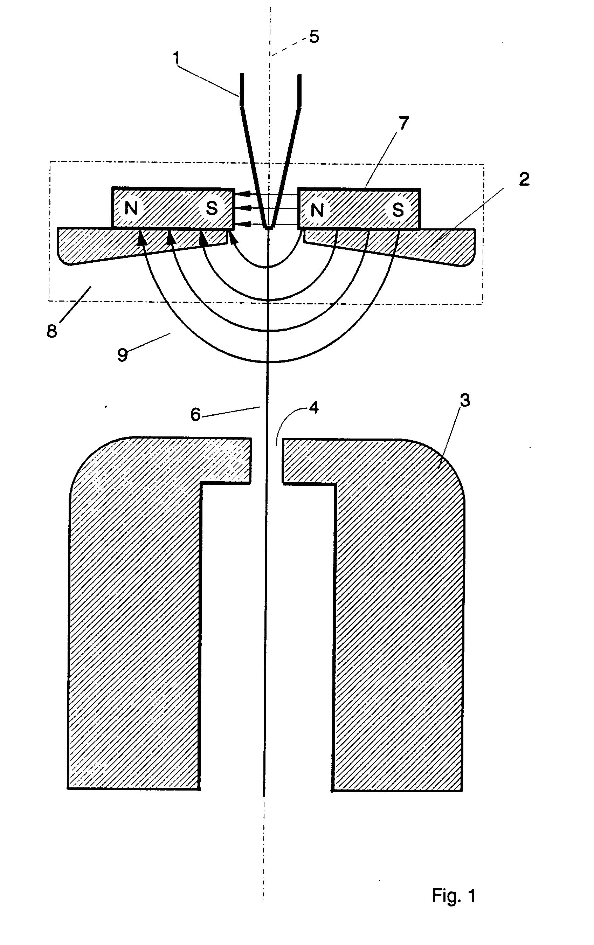

Fig. 1 zeigt den schematischen Aufbau eines Elektronenstrahl-Erzeugers in einem Schnittbild in Richtung einer Strahlenachse.
Der Elektronenstrahl-Erzeuger besteht aus einer Kathode (1), einer ringförmigen Wehneltelektrode (2) und einer Anode (3) mit einer Anodenbohrung (4), die entlang einer Strahlenachse (5) positioniert und in einer nicht dargestellten Vakuumkammer angeordnet sind. Als Kathode (1) wird beispielsweise eine direkt oder indirekt beheizte Bandkathode aus Wolfram verwendet. Die Kathode (1) liegt z.B. auf einem Potential von -35 kV, die Wehneltelektrode (2) auf einem Potential von -35,6 kV, und die Anode (3) hat Nullpotential. Die Elektronen, die einen Elektronenstrahl (6) bilden, werden aus der Emissionsfläche der Kathode (1) emittiert, treten durch die Wehneltelektrode (2) hindurch und werden in Richtung der Anode (3) beschleunigt. Die Elektronen verlassen den Elektronenstrahl-Erzeuger durch die Anodenbohrung (4). Die Wehneltelektrode (2) dient zur Steuerung des Strahlstromes. Bei einem bestimmten Wert einer Steuerspannung für die Wehneltelektrode (2) emittieren keine Elektronen aus der Kathode (1), d.h. es gibt keine auf die Anode (3) gerichteten elektrischen Feldvektoren, welche die Elektronen in Richtung der Anode (3) beschleunigen. Bei emiedrigter Steuerspannung erhöht sich der Anodendurchgriff, und es wird ein immer größerer Bereich der Emissionsfläche der Kathode (1) freigegeben.

In dem Elektronenstrahl-Erzeuger entstehen durch Ionisation von Restgasmolekülen Ionen, die bei herkömmlichen Elektronenstrahl-Erzeugern auf die Kathode (1) beschleunigt werden. Der durch den lonenbeschuß bedingte Materialabtrag verkleinert die aktive Emissionsfläche der Kathode (1), und das charakteristische Strahlstromprofil des Elektronenstrahles (6) wird in nachteiliger Weise verändert. Dabei sind insbesondere die aus dem Beschleunigungsraum zwischen Kathode (1) und Anode (3) stammenden Ionen an der Zerstörung der Kathode (1) beteiligt.

Der Elektronenstrahl-Erzeuger weist erfindungsgemäß eine magnetische Kathoden-Schutzvorrichtung (7) auf, nachfolgend mit magnetischem lonen-Separator (7) bezeichnet. Der magnetische lonen-Separator (7) ist in dem in Fig. 1 dargestellten Ausführungsbeispiel in der Nähe der Kathode (1) angeordnet, zu dieser zentriert und mit der Wehneltelektrode (2) konstruktiv vereinigt.

Kathode (1), magnetischer lonen-Separator (7) und Wehneltelektrode (2) sind zu einer Strahlerzeugungseinheit (8) zusammengefaßt, die in der Vakuumkammer senkrecht zur Strahlenachse (5) relativ zur Anode (3) verschiebbar gelagert ist. Die Konstuktion der verschiebbaren Strahlerzeugungseinheit (8) ist so getroffen, daß eine genaue Positionierung durch außerhalb der Vakuumkammer befindliche Stellmittel auch während des Betriebes möglich ist.

Der magnetische lonen-Separator (7) erzeugt ein im wesentlichen senkrecht zur Strahlenachse (5) bzw. senkrecht zur Bewegungsrichtung der Elektronen verlaufendes statisches, transversales Magnetfeld (9), von dem in Fig. 1 einige Magnetfeldlinien angedeutet sind. Das transversale Magnetfeld (9) wirkt im Bereich des Elektronenstrahles (6) zwischen Kathode (1) und Anode (3), vorzugsweise in der Kathodenebene. Die magnetische Feldstärke des transversalen Magnetfeldes (9) nimmt in Richtung auf die Anode (2) ab. Vorzugsweise hat die magnetische Feldstärke in der Nähe der Kathode (1) einen Maximalwert, dann einen starken Abfall in Richtung auf die Anode (3) und im Bereich der Anode (3) einen kleinen nahezu konstanten Wert.

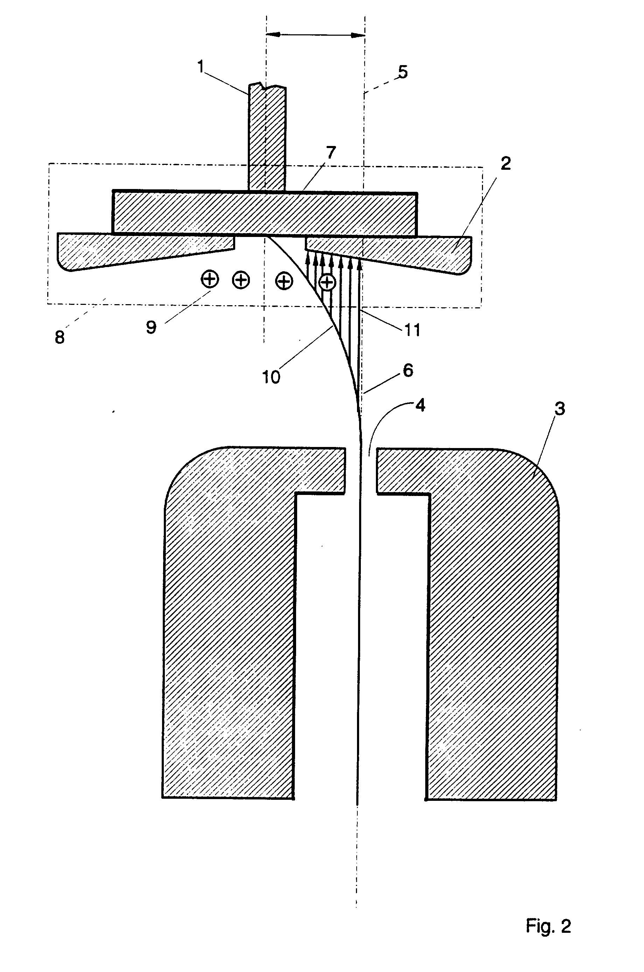

Das in dem magnetischen lonen-Separator (7) erzeugte transversale Magnetfeld (9) lenkt die Elektronen aufgrund der Lorenzkraft senkrecht zum transversalen Magnetfeld (9), d. h. senkrecht zur Zeichnungsebene aus der Strahlenachse (5) ab. Dahingegen werden die lonen wegen ihrer größeren Masse durch das transversale Magnetfeld (9) nur gering beeinflußt und folgen dem elektrischen Feld, wodurch eine Trennung der lonen von den Elektronen des Elektronenstrahles (6) erreicht wird. Die Ablenkung der Elektronen bewirkt eine Krümmung des Elektronenstrahles (6) auf dem Weg zur Anode (3), was in Fig. 2 dargestellt ist.

Fig. 2 zeigt den Elektronenstrahl-Erzeuger in einem gegenüber der Darstellung in Fig. 1 um 90° um die Strahlenachse (5) gedrehten Schnittbild. Dargestellt ist auch die gekrümmte.Bahn (10) des Elektronenstrahles (6) zwischen Kathode (1) und Anode (3) aufgrund der Ablenkung des Elektronenstrahles (6) durch das transversale Magnetfeld (9) des magnetischen lonen-Separators (7).

Die aus Kathode (1), magnetischem lonen-Separator (7) und Wehneltelektrode (2) gebildete Strahlerzeugungseinheit (8) ist senkrecht zur Strahlenachse (5) entgegen der Ablenkrichtung des Elektronenstrahles (6) aus der Strahlenachse (5) heraus verschoben angeordnet, wodurch die Strahlenachse (5) nicht mehr durch die Öffnung der Wehneltelektrode (2) und durch die Kathode (1), sondem durch die Elektrodenfläche der Wehneltelektrode (2) verläuft.

Die Verschiebung der Strahlerzeugungseinheit (8) relativ zur Anode (3) und/oder die Feldstärke des transversalen Magnetfeldes (9) ist dabei derart gewählt, daß der gekrümmte Elektronenstrahl (6) im Bereich der Anode (3) wieder in die Strahlenachse (5) einmündet und dann innerhalb der Anodenbohrung (4) in der Strahlenachse (5) selbst verläuft.

Durch diese erfindungsgemäßen Maßnahmen wird in vorteilhafter Weise erreicht, daß ein Großteil der lonen aufgrund ihrer größeren Masse nicht der gekrümmten Bahn (10) des Elektronenstrahles (6) folgen und in störender Weise auf die Kathode (1) prallen, sondern auf lonenbahnen (11) geradeaus in Richtung der Strahlenachse (5) fliegen und dabei wegen der Verschiebung der Strahlerzeugungseinheit (8) auf die Wehneltelektrode (2) prallen. Durch den geringeren lonenbeschuß der Kathode (1) wird somit in vorteilhafter Weise erreicht, daß die Betriebszeit bzw. Standzeit, d.h. die nutzbare Zeit, der Kathode (1) entscheidend verlängert wird. Darüber hinaus wird ein gleichmäßigerer Materialabtrag von der Emissionsfläche der Kathode (1) und damit ein verbessertes Strahlstromprofil des Elektronenstrahles (6) erreicht.

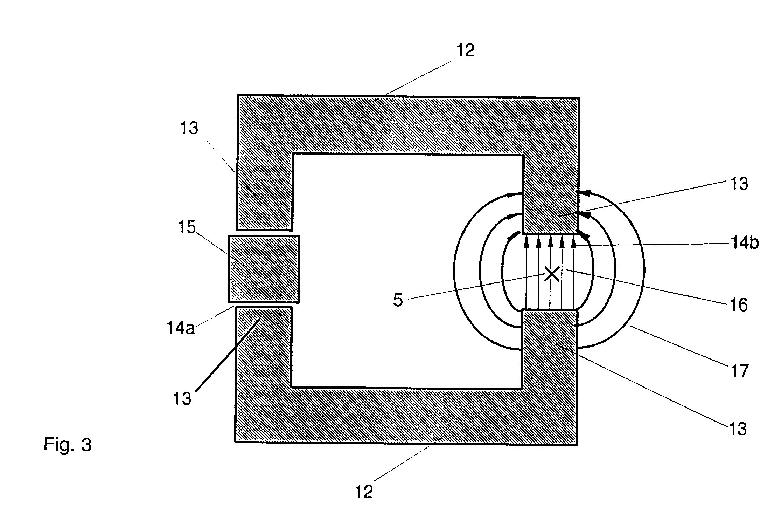

Fig. 3 zeigt ein Ausführungsbeispiel für den magnetischen lonen-Separator (7) in einem Schnittbild senkrecht zur Strahlenachse.

Der magnetische lonen-Separator (7) besteht beispielsweise aus zwei U-förmigen Polschuhen (12), deren Schenkel(13) sich gegenüber liegen und voneinander beabstandet sind, so daß Luftspalte (14) gebildet werden. In dem einen Luftspalt (14a) befindet sich ein Permanentmagnet (15), der in dem anderen Luftspalt (14b) ein nahezu homogenes Magnetfeld (16) mit einem außerhalb des Luftspaltes (14b) verlaufenden magnetischen Streufeld (17) erzeugt.

In dem Elektronenstrahl-Erzeuger ist die aus den Polschuhen (12) und dem Permanentmagneten (15) gebildete Einheit senkrecht zur Strahlenachse (5) angeordnet und derart ausgerichtet, daß die Strahlenachse (5) durch den Luftspalt (14b) verläuft und das Streufeld (17) das transversale Magnetfeld (9) in der Kathodenebene erzeugt.

Die Polschuhe (12) bestehen beispielsweise aus Weicheisen. Da der Permanentmagnet (15) aufgrund seiner Nähe zur hocherhitzten Kathode (1) hohen thermischen Belastungen ausgesetzt ist, muß ein Magnetwerkstoff verwendet werden, dessen magnetische Eigenschaften eine geringe reversible Abhängigkeit von der Temperatur haben.

Die Erzeugung des transversalen Magnetfeldes (9) und die Ausbildung des magnetischen lonen-Separators (7) ist nicht auf das beschriebene Ausführungsbeispiel beschränkt.

## Patentansprüche

1. Elektronenstrahl-Erzeuger, bestehend aus einer Elektronen emittierenden Kathode (1), einer Anode (3) mit einer Anodenbohrung (4) zum Durchtritt des aus den Elektronen gebildeten Elektronenstrahles (6) entlang einer Strahlenachse (5) und aus einer zwischen Kathode (1) und Anode (3) angeordneten Wehneltelektrode (2) zur Steuerung des Elektronenstrahles (6), wobei sich Kathode (1), Anode (3) und Wehneltelektrode (2) in einer Vakuumkammer befinden, **dadurch gekennzeichnet** , daß zur Verringerung der Anzahl von auf die Kathode (1) auftreffenden, durch lonisation von Restmolekülen gebildeten lonen
- die Kathode (1) zusammen mit der Wehneltelektrode (2) in der Vakuumkammer im wesentlichen senkrecht zur Strahlenachse (5) relativ zur Anode (2) verschiebbar sind **und**
- zwischen Kathode (1) und Anode (3) eine magnetische Kathoden-Schutzvorrichtung (7) angeordnet ist, die im Bereich des Elektronenstrahles (6) ein statisches, im wesentlichen senkrecht zur Strahlenache (5) verlaufendes transversales Magnetfeld (9) erzeugt, welches den von der Kathode (1) kommenden Elektronenstrahl (6) aus der Strahlenachse (5) ablenkt, wobei Kathode (1) und Wehneltelektrode (2) entgegen der Ablenkrichtung des Elektronenstahles (6) derart verschoben sind und/oder die Feldstärke des transversalen Magnetfeldes (9) derart gewählt ist, daß der abgelenkte Elektronenstrahl (6) im Bereich der Anode (3) wieder in der Strahlenachse (5) verläuft.

2. Elektronenstrahl-Erzeuger nach Anspruch 1, **dadurch gekennzeichnet** , daß die magnetische Kathoden-Schutzvorrichtung (7) derart angeordnet ist, daß das transversale Magnetfeld (9) im Bereich der Kathode (1) wirksam ist.

3. Elektronenstrahl-Erzeuger nach Anspruch 1 oder 2, **dadurch gekennzeichnet**, daß die Feldstärke des transversalen Magnetfeldes (9) im Bereich der Kathode (1) einen Maximalwert hat, dann stark abfällt und im Bereich der Anode (3) einen kleinen Wert aufweist.

4. Elektronenstrahl-Erzeuger nach einem der Ansprüche 1 bis 3, **dadurch gekennzeichnet**, daß die magnetische Kathoden-Schutzvorrichtung (7) zentriert zur Strahlenachse (5) an der Wehneltelektrode (2) angeordnet ist.

5. Elektronenstrahl-Erzeuger nach einem der Ansprüche 1 bis 4, **dadurch gekennzeichnet**, daß die Kathode (1), die Wehneltelektrode (2) und die magnetische Kathoden-Schutzvorrichtung (7) eine innerhalb der Vakuumkammer verschiebbare bauliche Einheit (8) bilden, die durch außerhalb der Vakuumkammer befindliche Stellmittel positionierbar ist.

6. Elektronenstrahl-Erzeuger nach einem der Ansprüche 1 bis 5, **dadurch gekennzeichnet,** daß
- die magnetische Kathoden-Schutzvorrichtung (7) aus zwei U-förmigen Polschuhen (12) besteht, deren Schenkel (13) sich gegenüberliegen und voneinander beabstandet sind, wodurch Luftspalte (14a, 14b) gebildet werden,
- in dem ersten Luf tspalt (14a) ein Permanentmagnet (15) angeordnet ist, der in dem zweiten Luftspalt (14b) ein Magnetfeld (16) mit einem Streufeld (17) außerhalb des Luftspaltes (14b) erzeugt **und**
- die magnetische Kathoden-Schutzvorrichtung (7) derart angeordnet ist, daß die Strahlenachse (5) durch den zweiten Luftspalt (14b) senkrecht zum Magnetfeld (16) verläuft, wobei das Streufeld (17) das transversale Magnetfeld (9) bildet.

7. Elektronenstrahl-Erzeuger nach Anspruch 6, **dadurch gekennzeichnet**, daß die Polschuhe (12) aus Weicheisen bestehen.

8. Elektronenstrahl-Erzeuger nach Anspruch 6 oder 7, **dadurch gekennzeichnet**, daß der Permanentmagnet (15) aus einem Magnetwerkstoff besteht, dessen magnetische Eigenschaften temperaturstabil sind.

## Claims

1. An electron beam generator, consisting of a cathode (1) emitting electrons, an anode (3) with an anode bore (4) for the passage of the electron beam (6) formed from the electrons along a beam aids (5) and of a Wehnelt electrode (2) arranged between cathode (1) and anode (3) to control the electron beam (6), wherein cathode (1), anode (3) and Wehnelt electrode (2) are situated in a vacuum chamber, characterised in that to reduce the number of ions striking onto the cathode (1) and formed by ionisation of residual molecules
the cathode (1) together with the Wehnelt electrode (2) in the vacuum chamber are displaceable substantially perpendicular to the beam axis (5) relative to the anode (2) and
- between cathode (1) and anode (3) a magnetic cathode protection device (7) is arranged, which in the region of the electron beam (6) generates a static transverse magnetic field (9) running substantially perpendicularly to the beam axis (5), which magnetic field (9) deflects the electron beam (6) coming from the cathode (1) out from the beam aids (5), wherein cathode (1) and Wehnelt electrode (2) are displaced contrary to the deflection direction of the electron beam (6) such that, and/or the field intensity of the transverse magnetic field (9) is selected such that, the deflected electron beam (6) in the region of the anode (3) runs in the beam axis (5) again.

2. An electron beam generator according to Claim 1, characterised in that the magnetic cathode protection device (7) is arranged such that the transverse magnetic field (9) is effective in the region of the cathode (1).

3. An electron beam generator according to Claim 1 or 2, characterised in that the field intensity of the transverse magnetic field (9) in the region of the cathode (1) has a maximum value, then fails intensively and in the region of the anode (3) has a small value.

4. An electron beam generator according to one of Claims 1 to 3, characterised in that the magnetic cathode protection device (7) is arranged centred to the beam axis (5) on the Wehnelt electrode (2).

5. An electron beam generator according to one of Claims 1 to 4, characterised in that the cathode (1), the Wehnelt electrode (2) and the magnetic cathode protection device (7) form a structural unit (8) displaceable inside the vacuum chamber, which unit (8) is positionable by adjusting means situated outside the vacuum chamber.

6. An electron beam generator according to one of Claims 1 to 5, characterised in that
- the magnetic cathode protection device (7) consists of two U-shaped pole shoes (12), the shanks (13) of which lie opposite each other and are spaced apart from each other, whereby air gaps (14a, 14b) are formed,
- in the first air gap (14a) a permanent magnet (15) is arranged, which in the second air gap (14b) generates a magnetic field (16) with a stray field (17) outside the air gap (14b) and
- the magnetic cathode protection device (7) is arranged such that the beam axis (5) runs through the second air gap (14b) perpendicularly to the magnetic field (16), wherein the stray field (17) forms the transverse magnetic field (9).

7. An electron beam generator according to Claim 6, characterised in that the pole shoes (12) consist of soft iron.

8. An electron beam generator according to Claim 6 or 7, characterised in that the permanent magnet (15) consists of a magnetic material, the magnetic characteristics of which are stable with respect to temperature.

## Revendications

1. Générateur de faisceau d'électrons composé d'une cathode (1) émettant des électrons, une anode (3) avec un perçage d'anode (4) pour le passage du faisceau d'électrons (6) ainsi formé selon un axe de faisceau (5) et une électrode Wehnelt (2), placée entre la cathode (1) et l'anode (3), pour commander le faisceau d'électrons (6), la cathode (1), l'anode (3) et l'électrode de Wehnelt (2) se trouvant dans une chambre sous vide,
caractérisé en ce que
pour réduire le nombre d'ions formés par ionisation de molécules restantes, rencontrant la cathode (1),
- la cathode (1) avec l'électrode de Wehnelt (2), dans la chambre sous vide, peuvent coulisser essentiellement perpendiculairement à l'axe (5) du faisceau par rapport à l'anode (1) et
- entre la cathode (1) et l'anode (3) se trouve un dispositif de protection de cathode (7), magnétique, qui génère, dans la zone du faisceau d'électrons (6), un champ magnétique transversal (9), essentiellement perpendiculaire à l'axe (5) du faisceau, ce champ déviant le faisceau d'électrons (6) arrivant de la cathode (1) par rapport à l'axe (5) du faisceau,
la cathode (1) et l'électrode de Wehnelt (2) étant décalées par rapport à la direction de déflexion du faisceau d'électrons (6) et/ou l'intensité du champ magnétique transversal (9) étant choisie pour que le faisceau d'électrons dévié (6) passe dans la zone de l'anode (3) de nouveau suivant l'axe (5) du faisceau.

2. Générateur de faisceau d'électrons selon la revendication 1,
caractérisé en ce que
le dispositif de protection de la cathode (7), magnétique, est monté pour que le champ magnétique transversal (9) agisse dans la zone de la cathode (1).

3. Générateur de faisceau d'électrons selon la revendication 1 ou 2,
caractérisé en ce que
l'intensité du champ magnétique transversal (9), dans la zone de la cathode (1), présente une valeur maximale qui diminue alors fortement et présente, dans la zone de l'anode (3), une valeur faible.

4. Générateur de faisceau d'électrons selon l'une des revendications 1 à 3,
caractérisé en ce que
le dispositif de protection de cathode (7), magnétique, est centré sur l'axe (5) du faisceau au niveau de l'électrode de Wehnelt (2).

5. Générateur de faisceau d'électrons selon l'une des revendications 1 à 4,
caractérisé en ce que
la cathode (1), l'électrode de Wehnelt (2) et le dispositif de protection de cathode (7), magnétique, forment une unité (8) coulissante dans la chambre à vide, et qui se positionne à l'aide de moyens de réglage situés à l'extérieur de la chambre à vide.

6. Générateur de faisceau d'électrons selon l'une des revendications 1 à 5,
caractérisé en ce que
- le dispositif de protection de cathode, magnétique (7) se compose de deux pièces polaires (12) en forme de U dont les branches (13) sont écartées en regard l'une de l'autre à une certaine distance formant des entrefers (14a, 14b),
- un aimant permanent (15) étant placé dans le premier entrefer (14a) qui génère, dans le second entrefer (14b), un champ magnétique (16) avec un champ dispersé (17) situé à l'extérieur de l'entrefer (14b) et
- le dispositif de protection de cathode, magnétique (7) est monté pour que l'axe (5) du faisceau passe à travers le second entrefer (14b), perpendiculairement au champ magnétique (16), le champ dispersé (17) formant le champ magnétique transversal (9).

7. Générateur de faisceau d'électrons selon la revendication 6,
caractérisé en ce que
les pièces polaires (12) sont en fer doux.

8. Générateur de faisceau d'électrons selon la revendication 6 ou 7,
caractérisé en ce que
l'aimant permanent (15) est en une matière magnétique dont les propriétés magnétiques sont stables en température.
